(19)

Europäisches
Patentamt

European
Patent Office

Office européen
des brevets

(11) **EP 1 058 968 B1**

(12) **EUROPEAN PATENT SPECIFICATION**

(45) Date of publication and mention
of the grant of the patent:
**13.02.2013 Bulletin 2013/07**

(51) Int Cl.:
***H04B 1/16*** (2006.01)

(86) International application number:
**PCT/US1999/003286**

(21) Application number: **99908178.9**

(22) Date of filing: **23.02.1999**

(87) International publication number:
**WO 1999/043090 (26.08.1999 Gazette 1999/34)**

(54) **QUADRATURE-FREE RF RECEIVER FOR DIRECTLY RECEIVING ANGLE MODULATED SIGNAL**

QUADRATURFREIER HF EMPFÄNGER FÜR DIREKTEMPFANG EINES WINKEL-MODULIERTEN SIGNALS

RECEPTEUR RF SANS QUADRATURE, DESTINE A RECEVOIR DIRECTEMENT UN SIGNAL A MODULATION ANGULAIRE

(84) Designated Contracting States:
**AT BE CH CY DE DK ES FI FR GB GR IE IT LI LU MC NL PT SE**
Designated Extension States:
**AL LT LV MK RO SI**

(30) Priority: **23.02.1998 US 27742**

(43) Date of publication of application:
**13.12.2000 Bulletin 2000/50**

(73) Proprietor: **Panasonic Corporation**
**Kadoma-shi**
**Osaka 571-8501 (JP)**

(72) Inventor: **McCUNE, Earl, W.**
**Santa Clara, CA 95050 (US)**

(74) Representative: **Gassner, Wolfgang et al**
**Dr. Gassner & Partner**
**Patentanwälte**
**Marie-Curie-Strasse 1**
**91052 Erlangen (DE)**

(56) References cited:
**US-A- 4 164 623     US-A- 4 653 117**
**US-A- 5 461 643     US-A- 5 493 713**

- **ADACHI F: "ERROR RATE ANALYSIS OF DIFFERENTIALLY ENCODED AND DETECTED 16APSK UNDER RICIAN FADING", IEEE TRANSACTIONS ON VEHICULAR TECHNOLOGY, IEEE SERVICE CENTER, PISCATAWAY, NJ, US, vol. 45, no. 1, 1 February 1996 (1996-02-01), pages 1-11, XP000594660, ISSN: 0018-9545, DOI: 10.1109/25.481815**

**Description**

The present invention relates to radio receivers, particularly digital radio receivers.

Modulation can be defined as the alteration of some characteristic of a known signal or waveform, i.e., a carrier, as a function of some unknown signal or waveform that conveys information. In radio-frequency (RF) communication systems, the carrier is typically a sinusoid, and there are several methods of modulating the carrier. These include linear modulation, angle modulation, and various types of pulse modulation. Given a sinusoidal carrier described by the equation $A(t)\cos(\omega_c t + \phi(t))$, there are two parameters, the amplitude and the phase angle, that can be varied in accordance with an information signal. Linear modulation results when the amplitude is varied as a linear function of the information signal. Angle modulation includes phase modulation and frequency modulation. If a term is included in the argument of the sinusoidal function that varies in proportion to the information signal, the result is phase modulation. If the argument is such that the difference in the instantaneous frequency and the carrier frequency is proportional to the information signal, the result is frequency modulation.

Demodulation of RF signals has typically involved a quadrature detector having two branches, an I ("in-phase") branch and a Q ("quadrature" or 90° phase-shifted) branch. In the I branch, a received signal is multiplied by the cosine form of the carrier signal and then passed through a low-pass filter. In the Q branch, the received signal is multiplied by the sine form of the carrier signal and pass through a low-pass filter. Quadrature detectors of this type are linear, well-understood, and almost universally used. To obtain the information signal from the I and Q components produced by the respective I and Q branches of the quadrature detector, signal processing is performed. In particular, the phase of the signal may be obtained by taking the inverse tangent of the ratio of Q to I. The amplitude of the signal may be obtained according to the Pythagorean theorem by taking the square root of the sum of the squares of I and Q. These mathematical operations are non-linear.

Two salient observations may therefore be made concerning quadrature detection. First, detection proceeds in two steps, a first mixing step (to obtain I and Q) that is linear and a second signal processing step to which non-linearities are relegated. Second, a coordinate system conversion is first performed and then reversed. That is, the received signal, which may be readily described in polar coordinates in terms of the desired quantities of amplitude and phase, is first converted to rectangular coordinates by projecting the instantaneous signal vector in polar coordinates onto the X (I) and Y (Q) axes, and is then converted back to polar coordinates to obtain amplitude and phase. Such conversions require circuitry that occupies space and consumes power-both of which may be precious commodities, especially in mobile applications such as cellular telephones, pagers, etc. Such conversions may also entail substantial inaccuracies.

The article « XP000594660 IEEE Transactions on Vehicular Technology, vol 45, N°1, 01-02-1996, Error rate analysis of differentially encoded and detected 16APSK under Rician fading, ADACHI Fumiyuki et al." discloses a receiver for receiving an amplitude modulation signal and a phase modulation signal. The receiver has two paths connected in parallel: the first having an ARD detector for receiving and detecting the amplitude modulation signal and the second having a DPD detector for receiving and detecting the phase modulation signal.

What is needed, then, is demodulation techniques that allow for space savings, power savings or increased accuracy to be obtained.

The present invention, generally speaking, provides a quadrature-free RF receiver for directly receiving RF signals such as angle modulated signals. The present invention provides a demodulator according to claim 1. Various embodiments of the receiver use a digital phase detector together with well-known RF components: a limiter, an envelope detector, a slow Automatic Gain Control (ACG) circuit, a fast ACG circuit, etc. Demodulation may be non-coherent or coherent. The approach followed is to handle the underlying non-linearities of the demodulation process within the circuitry itself, rather than relegating the non-linearities to a separate signal processing step as in the prior art. No I and Q signals are obtained, and no coordinate conversions are performed, offering the potential for space savings, increased accuracy, and especially power savings. Depending on the nature of the modulation employed, either circuitry relating to amplitude recovery or circuitry relating to phase recovery may be dispensed with. By comparison, in quadrature systems, at least the mixing step must remain the same regardless of the characteristics of the modulation employed.

Figure 1 is a block diagram of a quadrature-free radio receiver in accordance with one embodiment of the invention;

Figure 2 is a block diagram of a quadrature-free radio receiver in accordance with another embodiment of the invention;

Figure 3 is a block diagram of a quadrature-free radio receiver in accordance with another embodiment of the invention;

Figure 4 is a block diagram of a quadrature-free radio receiver in accordance with another embodiment of the invention;

Figure 5 is a block diagram of a quadrature-free radio receiver in accordance with another embodiment of the invention;

Figure 6 is a block diagram of a quadrature-free radio receiver in accordance with another embodiment of the invention;

Figure 7 is a block diagram of a quadrature-free radio receiver in accordance with another embodiment of the invention;

Figure 8 is a graph illustrating the accuracy obtained from a digital frequency discriminator using a constant weighting function;

Figure 9 is a graph illustrating the accuracy obtained from a digital frequency discriminator using a triangular weighting function;

Figure 10 is a block diagram of one example of a digital filter that may be used in conjunction with a frequency sampling circuit such as that of Figure 21;

Figure 11A is a tabulation illustrating one method of digital phase discrimination;

Figure 11B is a plot showing results of the method of Figure 11A;

Figure 11C is a plot of a weighting function used in connection with Figures 11A and 11B;

Figure 12A is a tabulation illustrating another method of digital phase discrimination;

Figure 12B is a plot showing results of the method of Figure 12A;

Figure 12C is a plot of a weighting function used in connection with Figures 12A and 12B;

Figure 13 is a block diagram of digital phase discrimination hardware in accordance with the technique of Figure 12;

Figure 14A is a tabulation illustrating yet another method of digital phase discrimination;

Figure 14B is a plot showing results of the method of Figure 14A;

Figure 14C is a plot of a weighting function used in connection with Figures 14A and 14B;

Figure 15 is a block diagram of digital phase discrimination hardware in accordance with the technique of Figure 14;

Figure 16A is a tabulation illustrating still another method of digital phase discrimination;

Figure 16B is a plot showing results of the method of Figure 16A;

Figure 16C is a plot of a weighting function used in connection with Figures 16A and 16B;

Figure 17 is a block diagram of digital phase discrimination hardware in accordance with the technique of Figure 16.

Figure 18 is a block diagram illustrating a sampled-data model of a Sigma-Delta modulator and of a sampling circuit applied to frequency sampling in accordance with one embodiment of the present invention;

Figure 19 is a table helpful in explaining operation of the circuit model of Figure 18 in the instance of an input frequency that is 0.6875 times a reference frequency;

Figure 20 is a timing diagram illustrating the principle of operation of the circuit model of Figure 18 as applied to frequency sampling;

Figure 21 is a schematic diagram of one example of a frequency sampling circuit described by the circuit model of Figure 18;

Figure 22 is a first timing diagram illustrating operation of the frequency sampling circuit of Figure 21;

Figure 23 is a second timing diagram illustrating operation of the frequency sampling circuit of Figure 21;

Figure 24 is a graph of two alternative weighting functions that may be used to perform digital filtering of a digital bit stream produced by a circuit such as that of Figure 21.

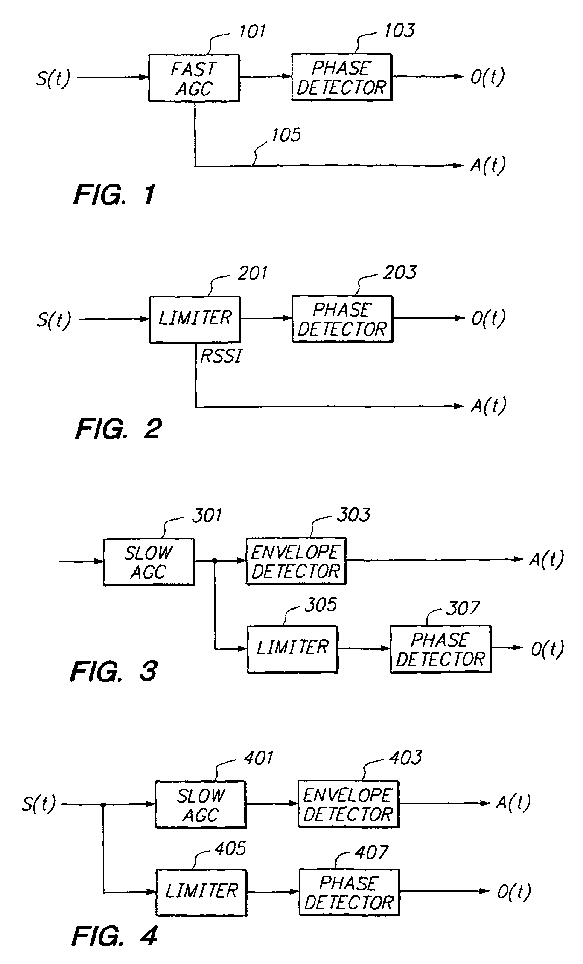

Referring now to Figure 1, a quadrature-free radio receiver in accordance with a first embodiment of the invention will be described. The receiver uses a phase detector, which may be of a type described in U.S. Patent Application No. 09/006,938 (Atty. Dkt. No. 32219-003), entitled DIGITAL PHASE DISCRIMINATION BASED ON FREQUENCY SAMPLING, filed January 14, 1998, incorporated hereinafter.

The foregoing digital phase detector either removes amplitude information from the received signal or assumes a fairly constant-amplitude signal. In the embodiment of Figure 1, therefore, the digital phase detector 103 is preceded by a fast AGC circuit 101 of a known type. A fast ACG circuit is able to track rapid amplitude variations. Such a circuit is essentially a variable-gain amplifier provided with feedback circuitry to sample the amplitude of the output signal, compare it with a desired amplitude, and control the gain of the amplifier accordingly. The control signal used to control the amplifier is therefore in inverse proportion to the amplitude of the received signal: if the received signal is of high amplitude, the control signal will be small in order to set the gain of the amplifier to a low level; if the received signal is of a low level, the control signal will be large in order to set the gain of the amplifier to a high level. The fast AGC circuit therefore operates to recover amplitude information, and the control signal 105 containing the amplitude information is output to a subsequent processing step. The subsequent processing step may be a signal processing step, much simplified as compared to that of the typical quadrature detector. The phase detector 103 recovers phase information directly from the constant-amplitude output signal of the fast ACG circuit 101.

Notice that the receiver of Figure 1 consists essentially of two blocks, one (101) for amplitude and one (103) for phase. These quantities are obtained directly in a quadrature-free manner, i.e., without IQ processing.

Referring to Figure 2, a similar effect may be achieved by substituting for the fast AGC circuit of Figure 1 a limiter 201 of a known type. Such limiters are used, for example, in AMPS cellular telephones, consist primarily of a saturating amplifier that amplifies the input signal to a fixed, predetermined level. The limiter also produces an RSSI (Received Signal Strength Indicator) signal indicative of the amplitude of the received signal. The RSSI signal is not strictly proportional to the received signal but is a monotonic function of the strength of the received signal (typically the logarithm of the amplitude of the received signal), from which the actual amplitude may be computed. As in Figure 1, the limiter of Figure 2 is followed by a phase detector that recovers phase information directly.

The series combination of a limiter and a phase detector as shown in Figure 2 proves to be a very useful combination and is used in other embodiments of the radio receiver. Referring to Figure 3, the combination of limiter 305 and phase detector 307 is used in conjunction with what is essentially an AM radio receiver-a slow AGC circuit 301 of a known type followed by an envelope detector 303 of a known type. The envelope detector recovers the amplitude information. In the example of Figure 3, the limiter/phase detector combination receives as its input signal the output signal of the slow ACG circuit. The limiter/phase detector combination could just as easily receive as it input signal the received signal itself, as shown in Figure 4. Operation does not differ appreciably whether the input signal to the limiter/phase detector combination is the received signal itself or the output signal of the slow ACG circuit, because of the high gain of the limiting amplifier.

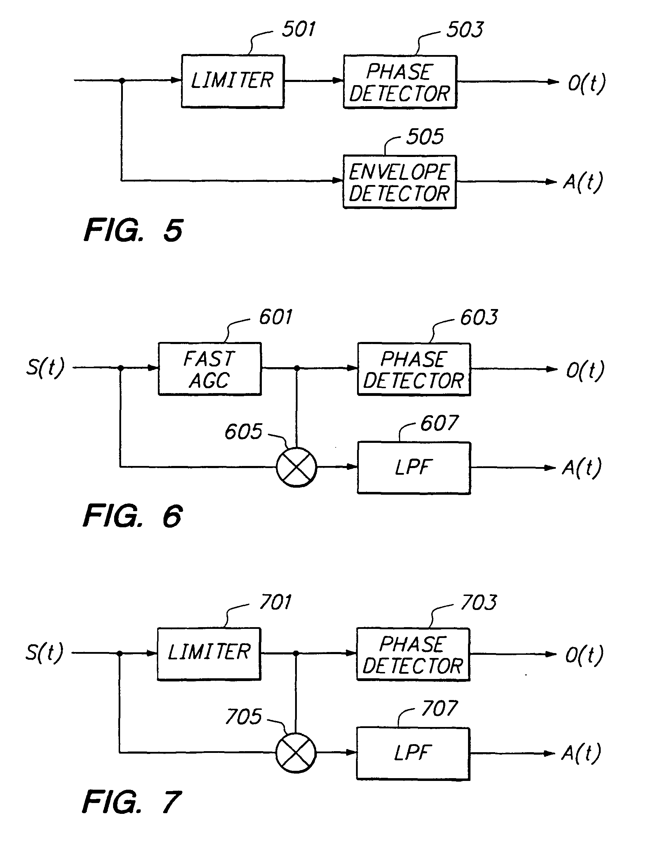

The radio receivers of Figure 3 and Figure 4 assume an open field radio propagation environment, i.e., wireless transmission. In the case of wired transmission, e.g., cable television transmission, the slow ACG circuit may be dispensed with. There results the radio receiver of Figure 5.

All of the radio receivers described thus far use non-coherent demodulation. Coherent demodulation may also be used. In coherent modulation, phase information is used to help recover amplitude information. More particularly, the received signal is multiplied by a replica of the received signal having the amplitude modulation removed. The multiplied signal is then low-pass filtered.

The coherent demodulators of Figure 6 and Figure 7, respectively, correspond generally to the non-coherent demodulators of Figure 1 and Figure 2. Referring to Figure 6, the received signal is input to the serial combination of a fast AGC circuit and a phase detector (601, 603). The phase detector 603 recovers the phase information. The input and output signals of the fast AGC circuit 601 are input to a multiplier 605, the output signal of which is low-pass filtered (607) to obtain the amplitude information.

The demodulator of Figure 7 is like that of Figure 6 with the exception that a limiter circuit 701 is substituted for the AGC circuit of Figure 6.

The phase demodulator of U.S. Patent Application No. 09/006,938 (Atty. Dkt. No. 32219-003), entitled DIGITAL PHASE DIESCRIMINATION BASED ON FREQUENCY SAMPLING, filed January 14, 1998, will now be described.

The approach followed by the digital frequency discriminator of the present invention may be appreciated by analogy to Sigma-Delta A/D conversion, well-documented in the prior art by such references as "Oversampling Delta-Sigma Data Converters", Candy, et al., IEEE Press, pages 1-6, Piscataway, NJ (1992). A Sigma-Delta converter modulates a varying-amplitude analog input signal into a simple digital code at a frequency much higher than the Nyquist rate. The design of the modulator allows resolution in time to be traded for resolution in amplitude. A sampled-data circuit model of a Sigma-Delta modulator, shown in Figure 1, may be directly applied to frequency sampling as described herein.

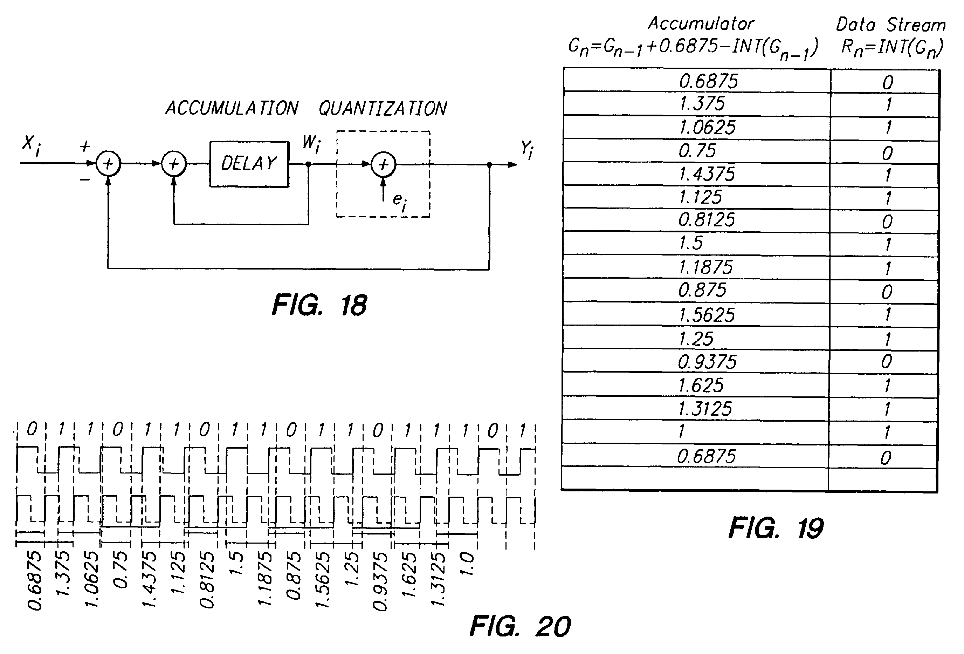

Referring to Figure 18, an input signal $x_i$ occurring at sample time i has subtracted from it the output signal $y_i$ at sample time i. The result is applied to an accumulator having an output signal $w_i$. A "new" input signal of the accumulator at sample time i is combined with the "old" output signal of the accumulator to form a new output signal of the accumulator. The output signal of the accumulator is quantized, the quantization being represented as the addition of an error $e_i$. The output signal of the quantizer is the final output signal $y_i$.

Assume now that $x_i$ is the ratio of two frequencies and that the quantizer is a two-level quantizer. Further assume that the ratio of the two frequencies for the time period in question is, say, 0.6875. As shown in Figure 19, the latter value is accumulated a first time, giving an accumulated value of 0.6875. This valuing being less than 1, the value 0.6875 is again added to the accumulated value, giving a new accumulated value of 1.375. Since this value is now greater than 1, 1 is subtracted from 0.6875 and the result (0.6875 - 1 = -0.3125) added to the accumulator to give a value of 1.0625. Operation proceeds in this fashion. During the foregoing sequence of operations, a data stream is produced by taking the integer portion, 1 or 0, of each accumulated value.

Referring to Figure 20, the interpretation of the sequence of numbers shown in Figure 19 may be appreciated. Two clock signals are shown. Again, it is assumed that the ratio of the frequency of the upper clock signal to that of the lower clock signal during the period of interest is 0.6875. At time t = 0, rising edges of both clock signals coincide. At the first subsequent rising edge of the lower clock signal, 0.6875 periods of the upper clock signal have elapsed. At the next rising edge of the lower clock signal, 1.375 periods of the upper clock signal have elapsed. At the next rising edge of the lower clock signal, 1.0625 periods of the upper clock signal have elapsed since the elapse of the first period of the upper clock signal, and so on.

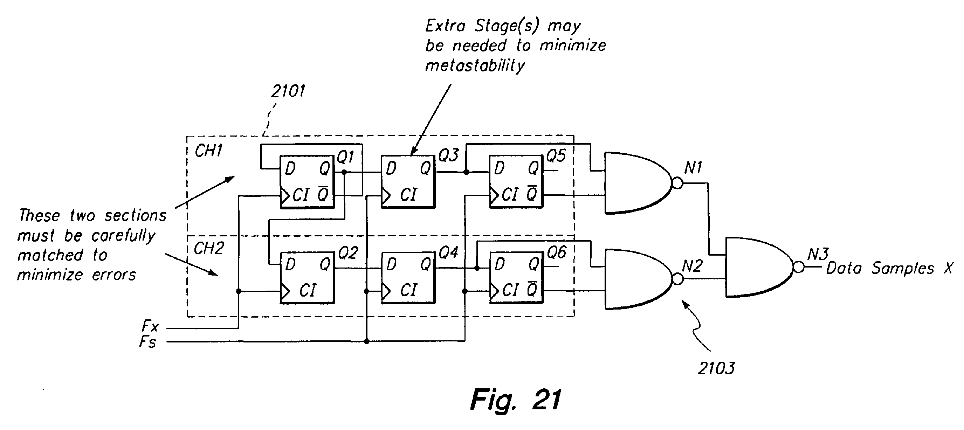

A schematic diagram of a capture circuit, or frequency sampling circuit, that may be used to data samples corresponding to the data stream described in the foregoing example is shown in Figure 21. In the illustrated embodiment, it is assumed that the ratio of the clock signals is such that no more than one rising edge of the faster clock will occur during a single period of the slower clock. In other embodiments, this assumption need not apply.

The capture circuit includes a input portion 2101 and an output portion 2103. The input portion includes two sections Ch1 and Ch2 that must be carefully matched to minimize errors. Each section comprises a chain of two or more D flip-flops coupled in series. In the following description, the same reference numerals will be used to reference the respective flip-flops themselves and their respective output signals.

Within each section, the first flip-flop in the chain is clocked by a sampled clock signal Fx. The succeeding flip-flops in the chain are clocked by a sampling clock signal Fs. The D input of the first flip-flop Q1 in the upper section is coupled to the $\overline{Q}$ output of the same. The D input of the first flip-flop in the lower section is coupled to the Q output of the first flip-flop in the upper section. The remaining flip-flops in both sections are coupled in series-i.e., Q to D, Q to D.

The function of the input portion is to 1) produce two signals, logical inverses of one another, that transition on rising edges of the clock signal Fx; 2) to latch the values of the two signals on the rising edge of the clock signal Fs; and 3) to detect transitions from one clock to the next. Additional intermediate stages in series with Q3 and Q4 may be required to minimize metastability resulting from the asynchrony of the two clock signals, and in fact multiple such stages may be desirable in a particular design.

The output portions include, in an exemplary embodiment, three two-input NAND gates. Respective NAND gates N1 and N2 are coupled to the D and $\overline{Q}$ signal of the final flip-flop stages of the input sections. Output signals of the NAND gates N1 and N2 are combined in the further NAND gate N3 to form the final output of the capture circuit.

The function of the output portion is to detect a change in the input clock signal level from one sample clock to the next in either of two channels formed by the two input sections. The two input sections function in a ping-pong fashion, alternately detecting changes in the input clock signal level.

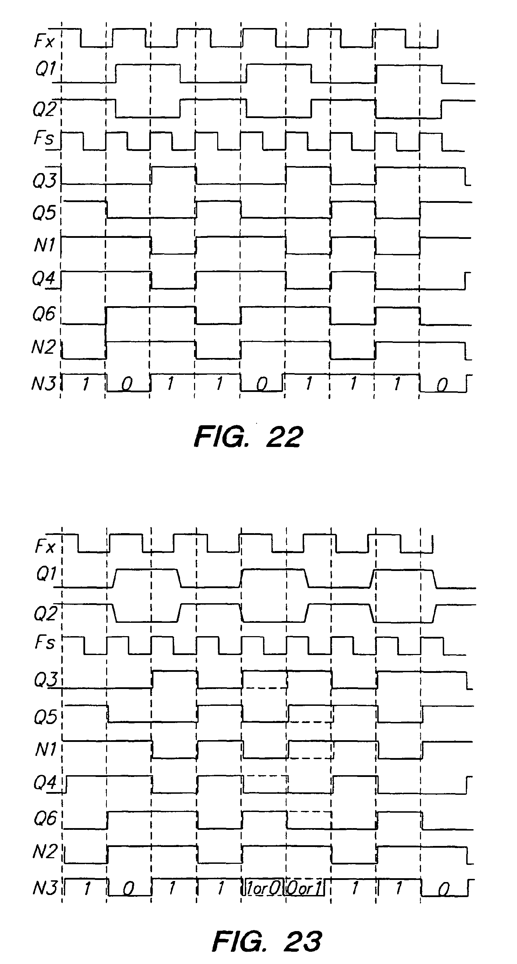

Operation of the capture circuit of Figure 21 may be more fully appreciated with reference to the timing diagram of Figure 22. The first stages of the two channels form inverse signals Q1 and Q2 approximately coincident with (but slightly delayed from) rising edges of the input clock signal. The signals Q3 and Q4 are formed by sampling the signals Q1 and Q2, respectively, in accordance with the sample clock. The signals Q5 and Q6, respectively, are delayed replicas of the signals Q3 and Q4. The NAND gates together realize the logic function $X = Q3 \cdot \overline{Q5} \text{ v } Q4 \cdot \overline{Q6}$.

In the example of Figure 22, the illustrated signals are all idealized square-wave signals. In actuality, the signals will have finite rise and fall times. The possible effect of the finite rise and fall times of the signals Q1 and Q2 and the asynchrony of the circuit is metastability, as illustrated in Figure 23. Here, the signals Q3 and Q5 and the signals Q4 and Q6 are each in an indeterminate state for one cycle. The resulting output of the circuit may or may not be correct. However, because the decision was a "close call" to begin with, the effect of an occasional erroneous decision on the overall operation of the circuit is negligible. The time window of instability is reduced by increasing the overall gain in the path. If the gain in Q3 and Q9 is sufficient to reduce the probability of an error to an acceptable level, then no additional circuitry is required. If not, then additional circuitry will be required to increase the gain.

In order to recover the ratio of the frequencies of the two clock signals from the data stream produced by a capture circuit such as the one of Figure 21, digital filtering is applied. Advantageously, an extensive body of digital filtering techniques applicable to Sigma-Delta (or Delta-Sigma) A/D converters may be applied directly to the digital stream. Furthermore, by using an appropriately-chosen weighting function, high accuracy may be obtained.

The weighted sum of products is an example of an FIR filter. The weighting function described heretofore is therefore that of an FIR filter in digital filtering theory. It should be recognized, however, that IIR filters can also be used. In the process of FIR digital filtering, the weighting function is applied to a "window" of data samples to obtain an estimate of the ratio of frequencies in the center of the window. The window is then "picked up and moved" to the next sequence of samples. Windowing will typically overlap. A window may include 256 samples, for example.

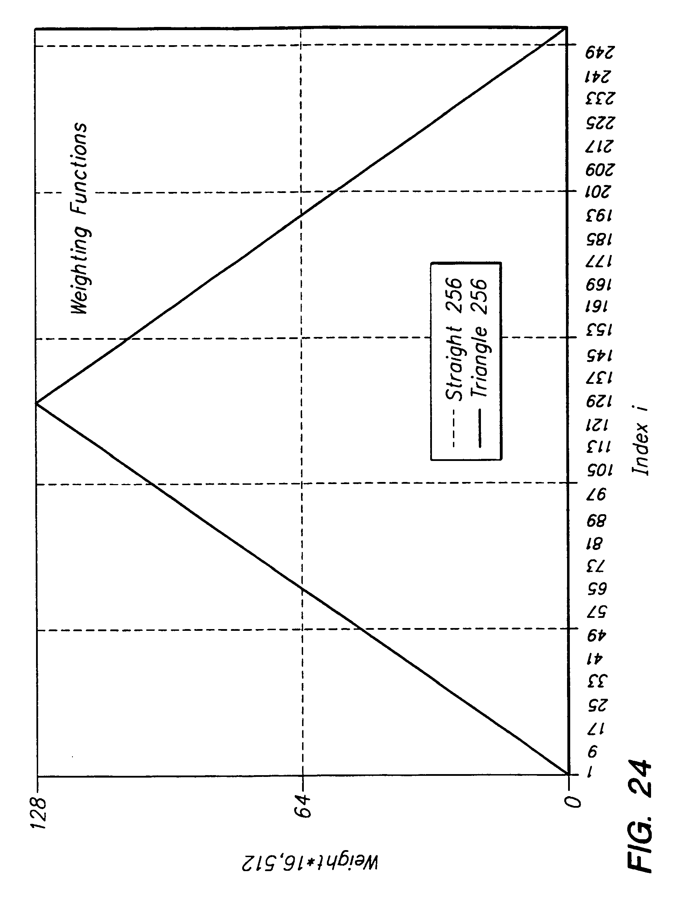

Referring to Figure 24, two alternative weighting functions are shown for a window of 256 samples. The weighting functions are normalized, meaning that the area under the weighting function is unity. One weighting function, indicated in dashed lines, is a straight-line, constant weighting function. Another weighting function, indicated in solid line, is a triangular weighting function. The weighting function is the impulse response function in digital filters.

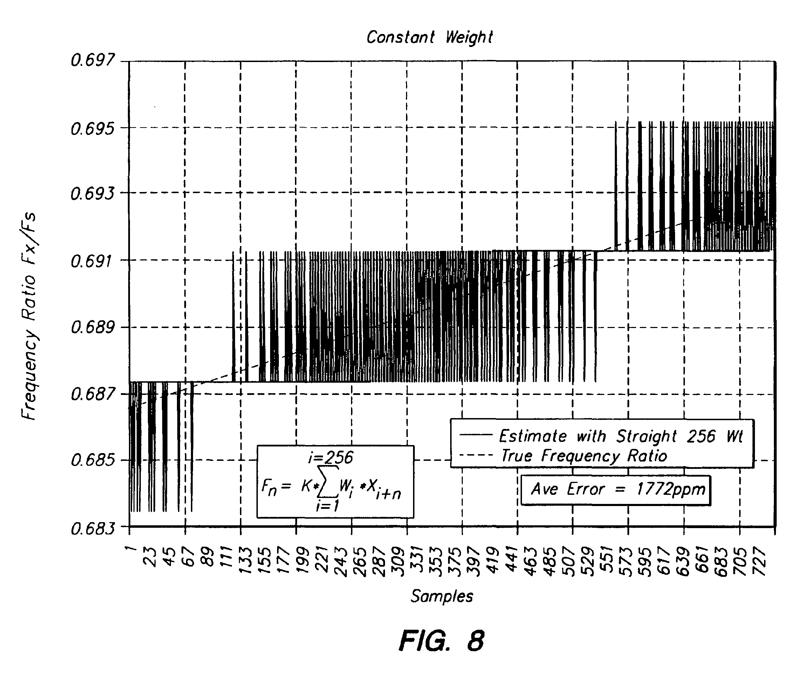

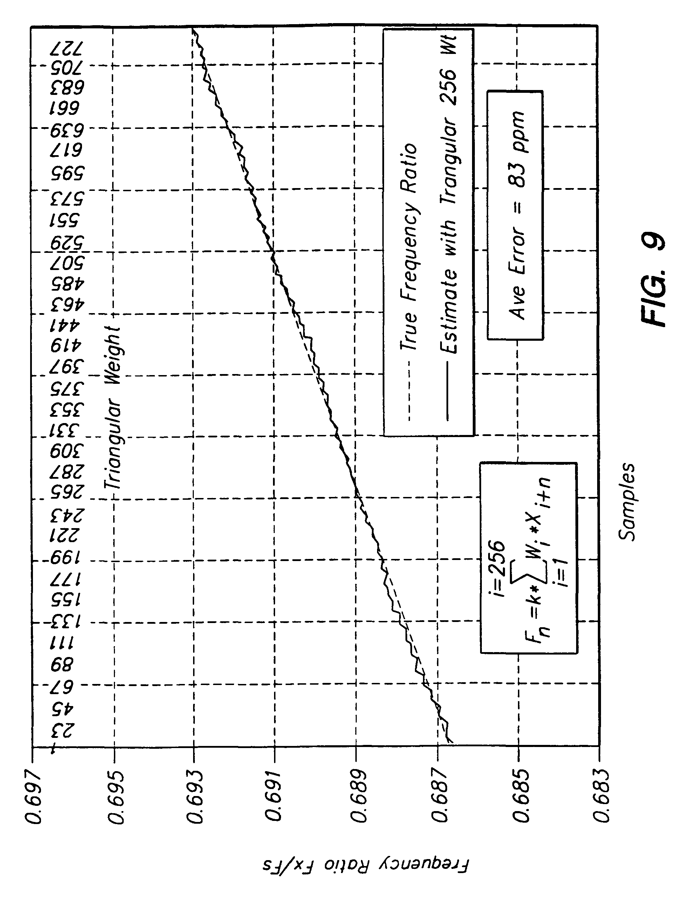

Results of digital filtering using the straight-line weighting function and the triangular weighting function respectively, are shown in Figure 8 and Figure 9. In the case of both Figure 8 and Figure 9, the frequency ratio was increased from just under 0.687 to just over 0.693. As seen in Figure 8, using a straight-line weighting function, the quantized signal oscillates between two levels that are adjacent to the input in such a manner that its local average equals the average input. The average error was calculated to be 1772ppm. As seen in Figure 9, using a triangular weighting function, the quantized signal tracks the input with an average error of 83ppm.

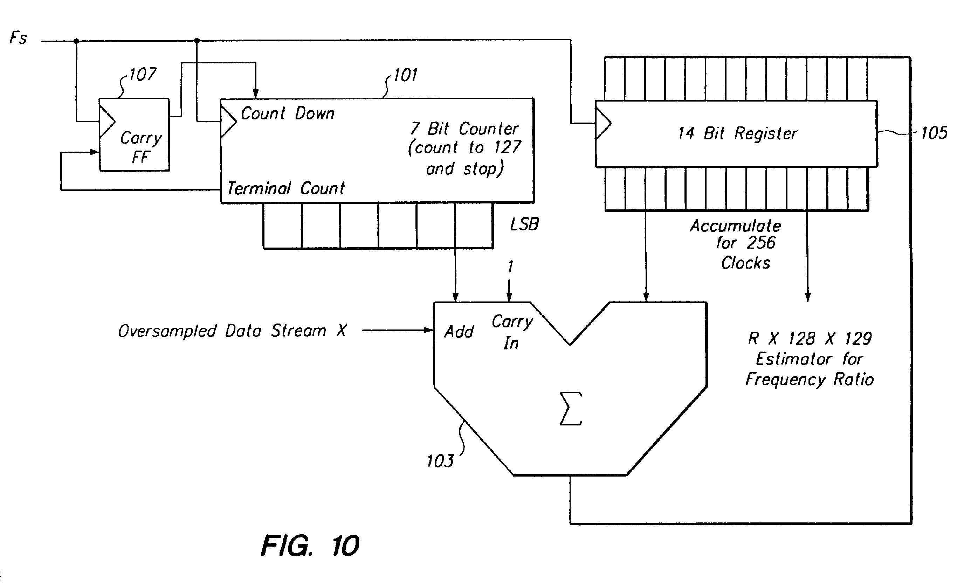

A schematic diagram of an exemplary frequency accumulator that applies a triangular weighting function and that may be used to accomplish the desired digital filtering is shown in Figure 10. In the example shown, the frequency accumulator uses a 7-bit counter 101, a 14-bit adder 103 and a 14-bit register 105. The 7-bit counter is clocked by the sample frequency Fs. The output of the 7-bit counter is provided to one input of the adder. The function of the 7-bit counter is to count up from 0 to 127 and then down from 127 to 0. The count of 127 occurs twice in succession. This behavior is achieved using a flip-flop 107. The flip-flop is clocked by the sample frequency Fs. A Terminal Count signal of the 7-bit adder is input to the flip-flop. The output of the flip-flop is coupled to a Count Down input of the 7-bit counter.

The "oversampled" data stream is coupled to a control input of the adder. When the current bit of the data stream is a 1, an addition is performed. When the current bit is a 0, no addition is performed. A Carry In input of the adder is tied high, effectively causing the range of weights to be 1 to 128.

The 14-bit register is clocked by the sample frequency Fs. Its output is applied to the other input of the adder. Its input receives the output word produced by the adder. The function of the 14-bit adder is to perform an accumulation operation for 256 clocks. At the conclusion of the 256 clocks, the output of the 14-bit adder is used as an estimator for the frequency ratio. More particularly, in the example shown, the output of the accumulator is equal to R x 128 x 129, where R is the frequency ratio estimator.

The foregoing technique may be readily extended to phase discrimination. Various different methods and apparatus for digital phase discrimination will be described entailing different design tradeoffs.

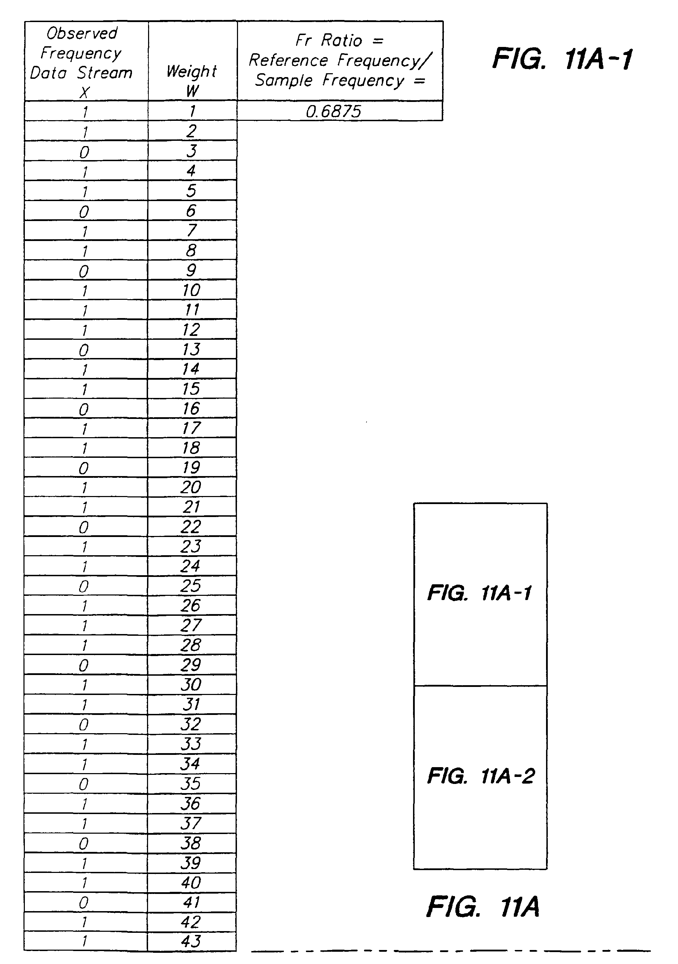

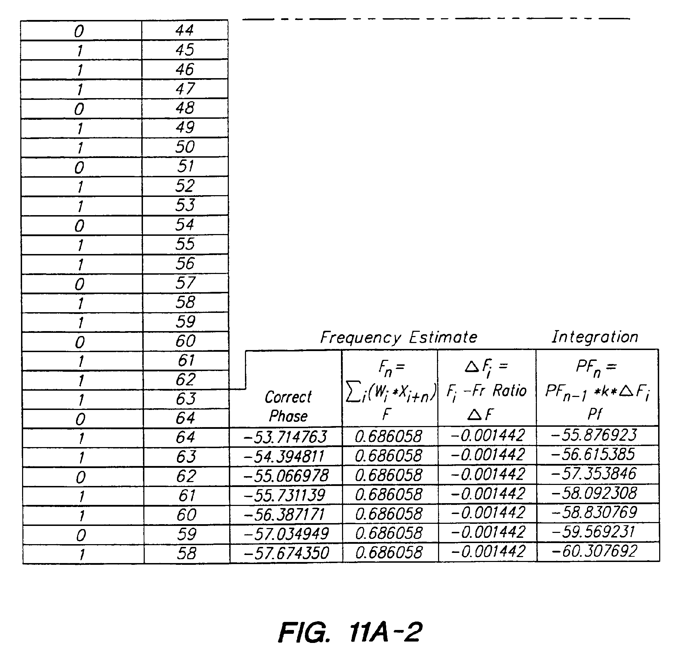

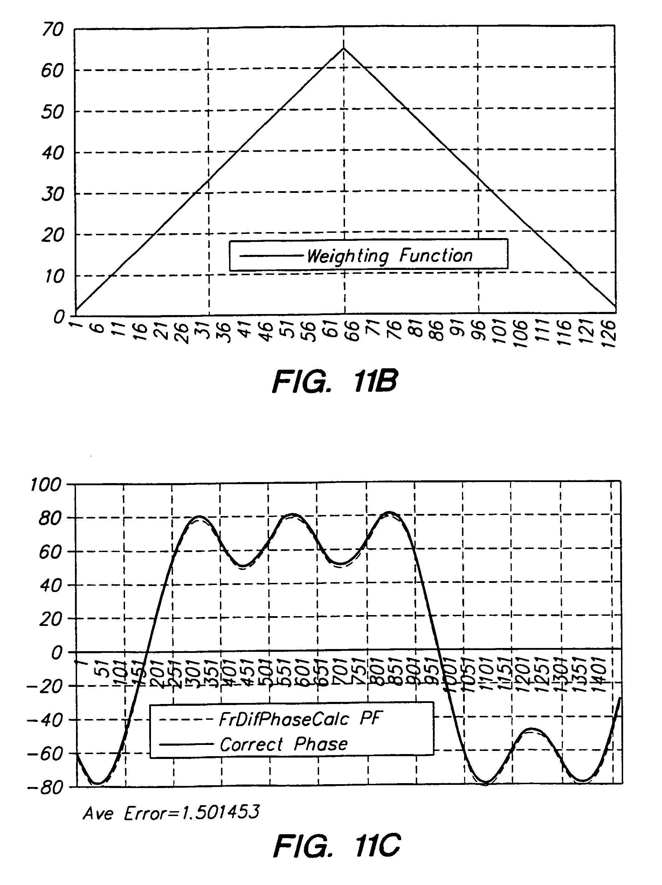

The first method is conceptually straightforward but computationally expensive. Referring to Figure 11A, the same observed frequency data stream and the same set of weights corresponding to a triangular weighting function (Fig. 11B) are used. The ratio of the reference frequency to the sampled frequency over a relatively long period of time is first determined using the technique described previously. Having obtained this frequency ratio estimator, short-term frequency deviations are estimated by calculating the same frequency estimate as before but at a relatively high rate, as often as once per sample period. That is, successive samples are all taken using the circuit of Figure 10, as often as each sample period. The difference ($\Delta F$) of each frequency estimate (F) from the previously-determined frequency ratio (Fr) is calculated, multiplied by an appropriate scale factor k and accumulated to obtain a corresponding phase estimate Pf. (The first value of Pf is an arbitrarily chosen initial condition, chosen for comparison to an ideal estimate. In practice, the phase may be initialized to a value based on a priori knowledge of signal characteristics, or, absent such a priori knowledge, may be set to zero upon detection of a phase inflection point.)

A phase-plot simulation comparing actual phase of a specified waveform (solid-line) with estimated phase using the foregoing phase estimation method (dashed-line) is shown in Fig. 11C.

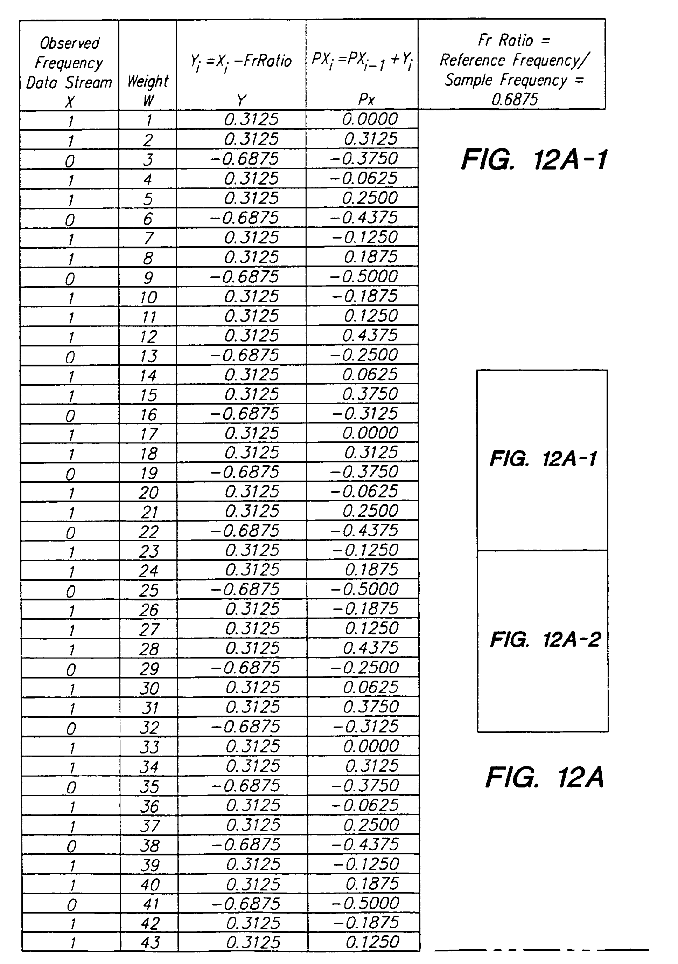

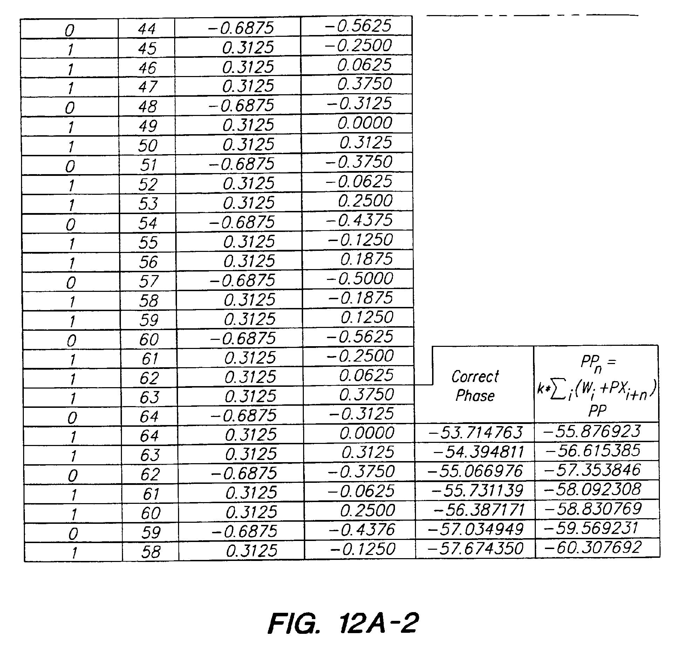

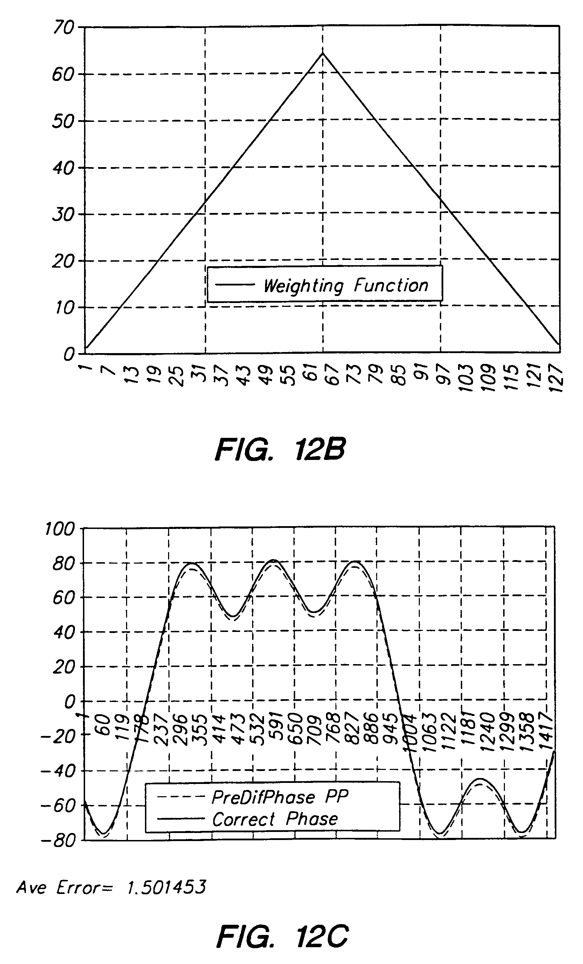

The foregoing "frequency difference" phase estimation method is computationally expensive because of the need to calculate frequency estimates at a relatively high rate. A "pre-summation difference" phase estimation method obviates this requirement. Referring to Figure 12A, instead of subtracting the frequency ratio from a frequency estimate, the frequency ratio Fr is subtracted from the sampled data stream itself. Assuming that the data stream is a bit stream of ones and zeros only, and assuming a frequency ratio Fr = 0.6875, then the pre-summation difference Y will have one of only two values, Y = 1 - 0.6875 = .3125 or Y = 0 - 0.6875 = - 0.6875. The Y values are accumulated to obtain corresponding values PX. Phase estimates $PP_n$ are obtained by filtering the PX values in substantially the same manner as described previously in relation to forming frequency estimates (using the identical weighting function, Fig. 12B, for example) with the exception that the filtered values are scaled by the scale-factor k.

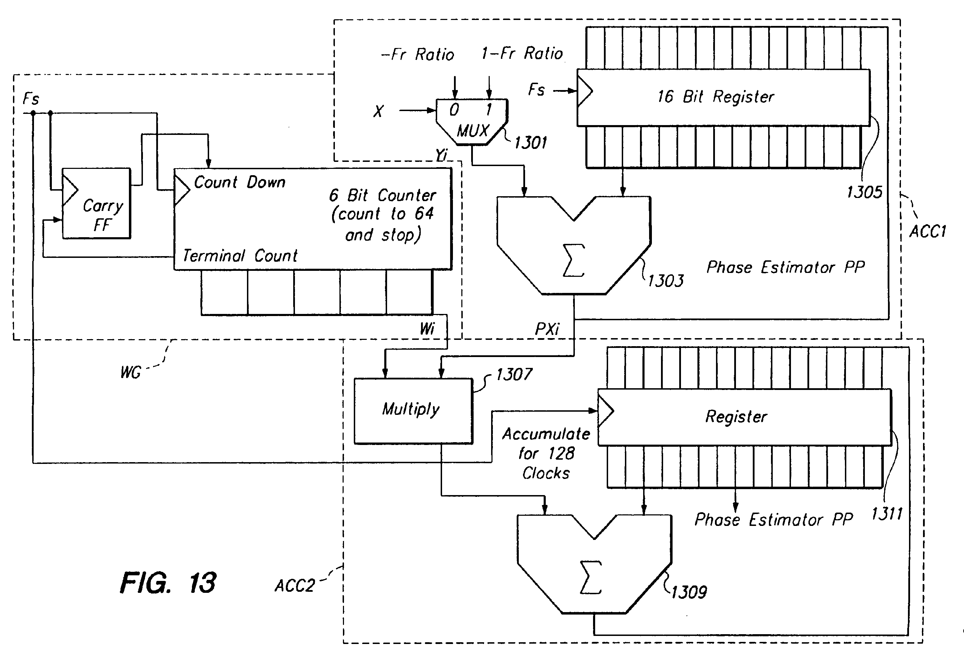

The pre-summation difference phase-calculation may be shown to be mathematically equivalent to the frequency difference phase calculation. Simulation results, shown in Fig. 12C, are therefore the same as in Fig. 11C. The hardware realization, however, may be considerably simpler using the pre-summation difference phase calculation, since only one computation is required per phase point. Such a hardware realization is shown in Figure 13.

The pre-summation difference phase estimator of Figure 13 includes generally a first accumulator ACC 1, a weight generator WG similar or identical to the weight generator previously described in relation to Figure 10, and a second accumulator ACC2.

The accumulator ACC1 functions to produce phase numbers $PX_i$ in correspondence to bits (or in other embodiments, symbols) of the observed frequency data stream and includes a multiplexer 1301, an adder 1303 and a register (e.g., a 16-bit register) 1305. The multiplexer 1301 selects one of the two possible values of $Y_i$ in accordance with the value of X and applies $Y_i$ to the adder 1303. The register value is added to $Y_i$ to form $PX_i$, which is then strobed into the register. The adder 1303 and register 1305 therefore accumulate the $PX_i$ values.

The $PX_i$ values are then filtered in the accumulator ACC2, which includes a multiplier 1307, an adder 1309 and a register 1311. The multiplier receives weights from the weight generator WG and $PX_i$ values from the accumulator ACC1. Respective weights and $PX_i$ values are multiplied and the products accumulated, e.g., for 128 clock cycles, to produce a phase estimator PP. The multiplier may be constructed so as to apply the scale factor k to each product during the accumulation process.

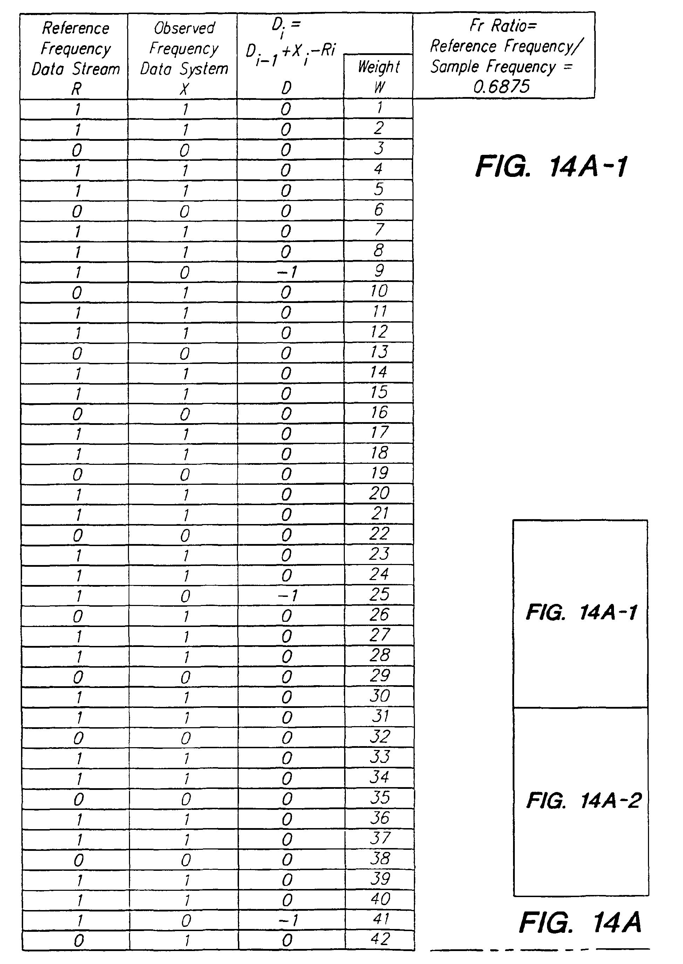

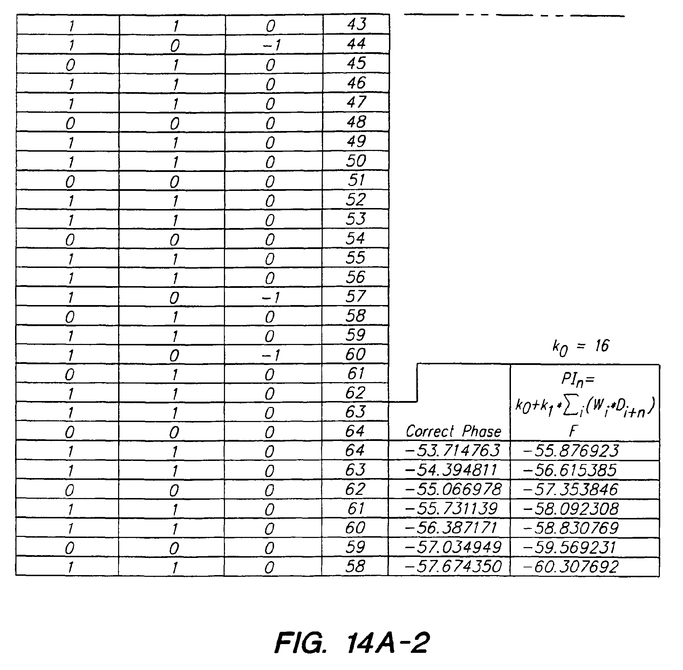

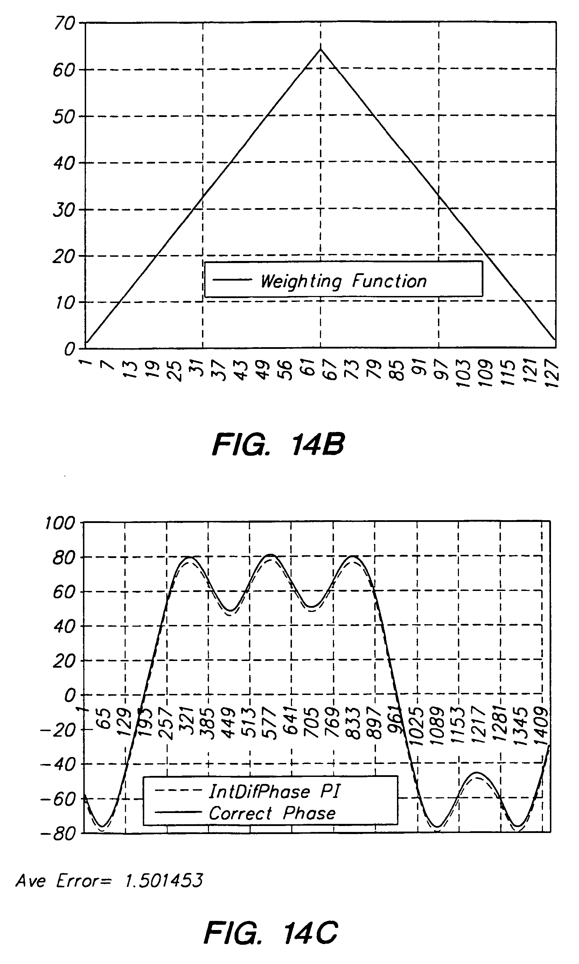

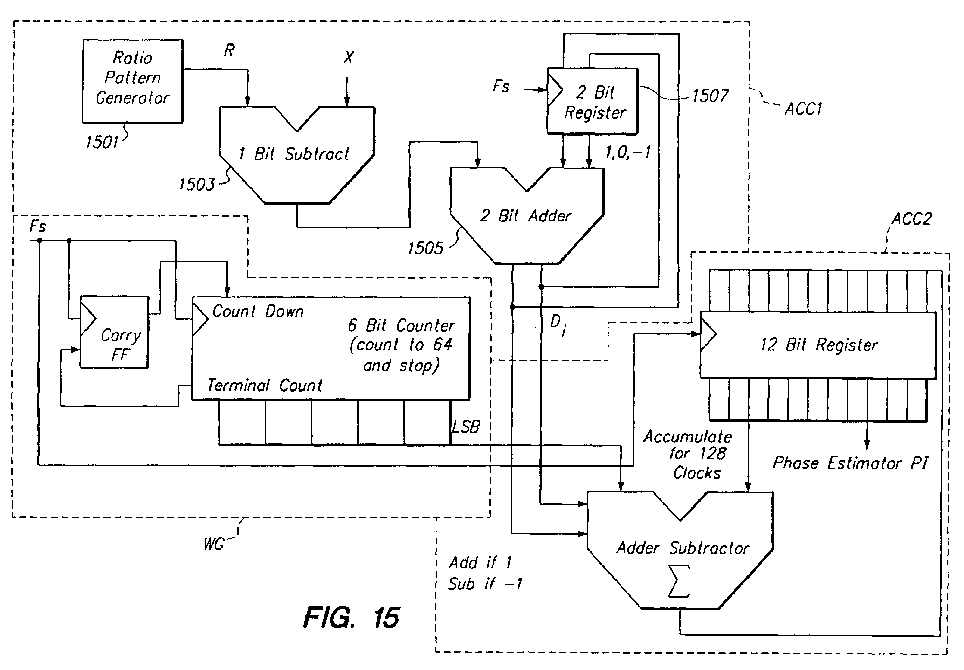

An even simpler realization may be achieved using an integer difference phase calculation. The integer difference phase calculation is not mathematically equivalent to the foregoing methods, but is very close. Referring to Fig. 14A, this method uses, in addition to the observed frequency data stream, a reference frequency data stream that would result if the reference frequency were applied to the capture circuit of Figure 4 (with the same clock). A running sum $D_i$ is then formed of the integer difference $X_i$-$R_i$. In many practical applications, such as the one illustrated in Figures 14 and 15, $D_i$ will have the values 1, 0 and -1 exclusively. The general case in which $D_i$ takes on other values may be appreciated and understood, however, from the present example, and is embraced by the present description.

Phase estimates are formed by filtering the $D_i$ values in the same or similar manner as previously described. The same triangular weighting function may be used Fig. 14B. The integer difference phase calculation method produces identical simulation results, Fig. 14C, as the preceding methods.

Referring to Figure 15, in the instance where D takes on the values 1, 0 and -1 exclusively, the corresponding hardware realization may be substantially simplified (as compared to that of Figure 13, for example).

The integer difference phase estimator of Fig. 15, like that of Fig. 13, includes generally a first accumulator ACC1, a weight generator WG, and a second accumulator ACC2. The accumulator ACC 1 is of considerably different construction than the corresponding structure of Figure 13. The accumulator ACC1 of Figure 15 includes a reference pattern generator 1501, a 1-bit subtractor 1503, a 2-bit adder 1505 and a 2-bit register 1507. The 1-bit subtractor subtracts respective R values from respective X values. The 2-bit adder and the register accumulate the resulting $D_i$ values which, as explained previously, may be constrained to 1, 0, -1 only.

The weight generator WG and the accumulator ACC2 are substantially the same as in Figure 13, described previously. However, because $D_i$ takes on the values 1, 0 and -1 exclusively, no multiplier is required. Instead, if $D_i$ = 1, the weight value is added to the accumulated value, and if $D_i$ = -1, the weight value is subtracted. (If $D_i$ = 0, the accumulated value remains unchanged.) The savings of a hardware multiplier is a particular advantage of the implementation of Fig. 15.

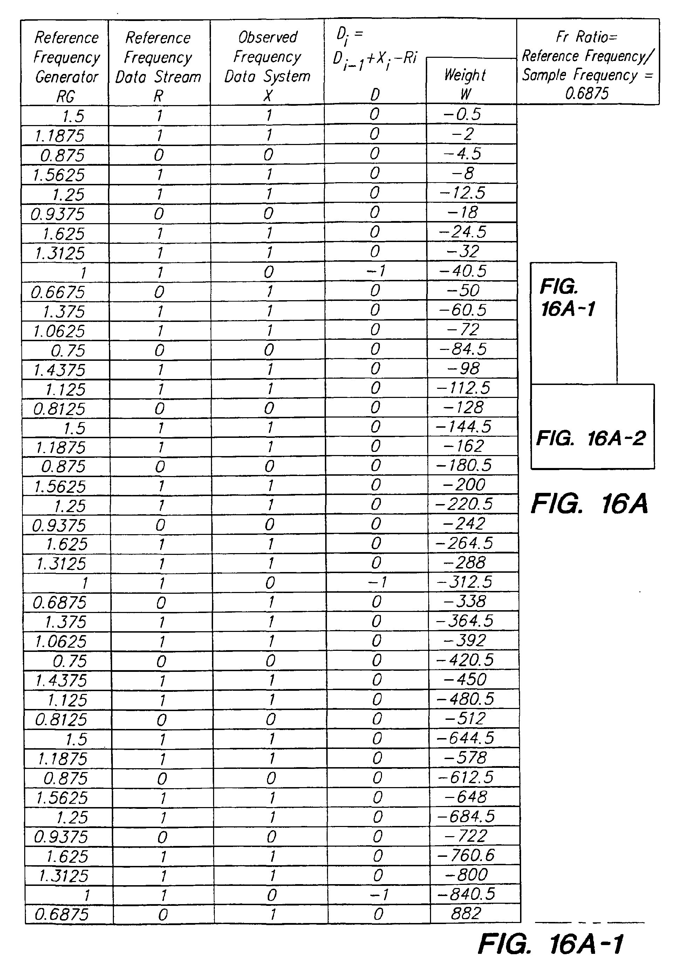

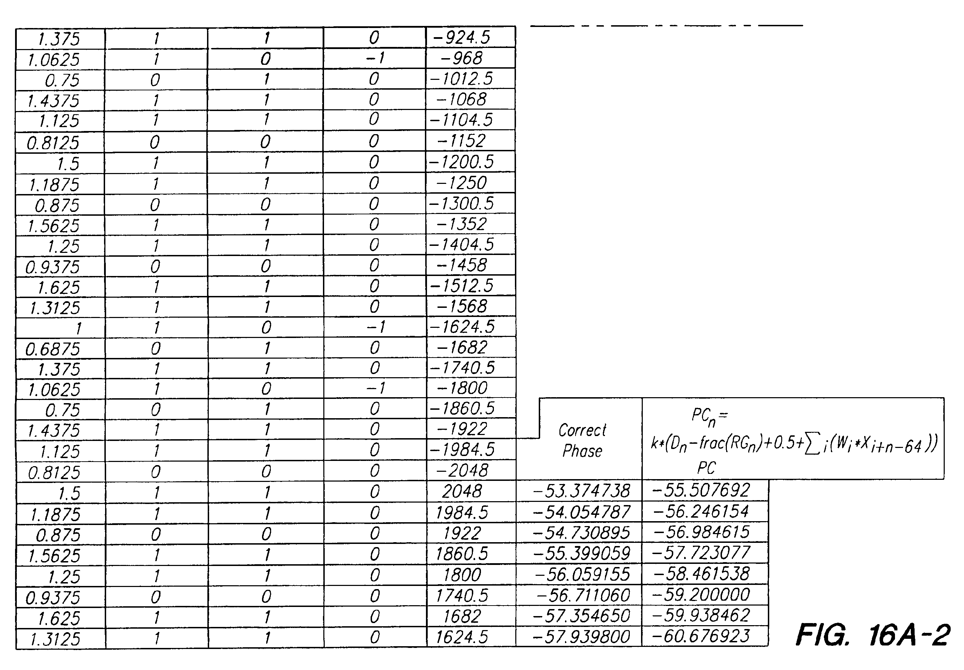

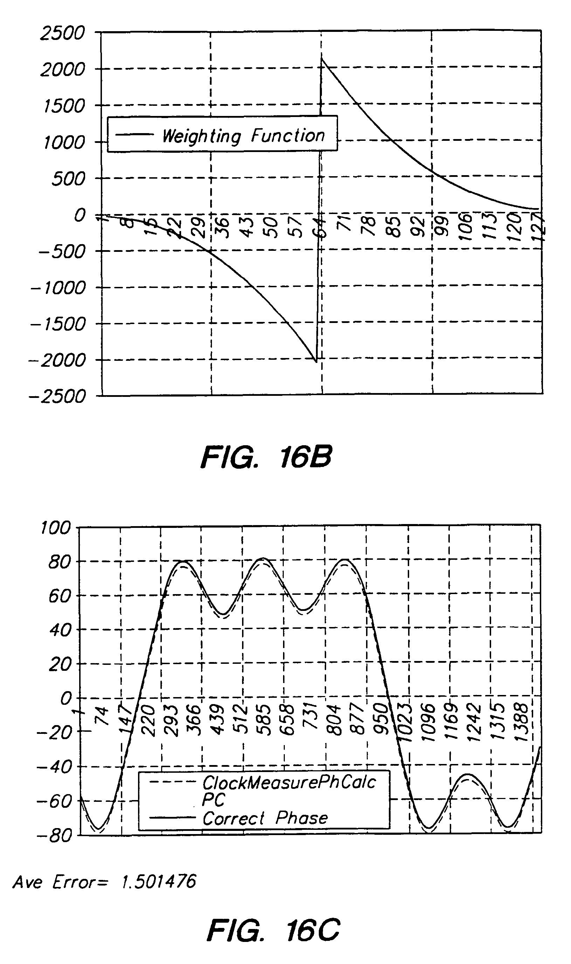

A further method of phase estimation is referred to as the clock measure phase calculation method. Referring to Figure 16A, this method is similar to the previous integer difference phase calculation method insofar as R, X and D are concerned. This method, however, uses in addition to the reference frequency data stream R, "clock measure" numbers RG, which are the same as the numbers appearing in Fig. 2. Moreover, the weight function used is distinctly different, as shown in Figure 16B. Clock measure phase estimate values PC are obtained using the following formula:

$$PC_n = k \cdot \left( D_n - fracRG_n + 0.5 + \sum_i (W_i \cdot X_{i+n-64}) \right)$$

Simulation results using the clock measure phase calculation method are shown in Figure 16C.

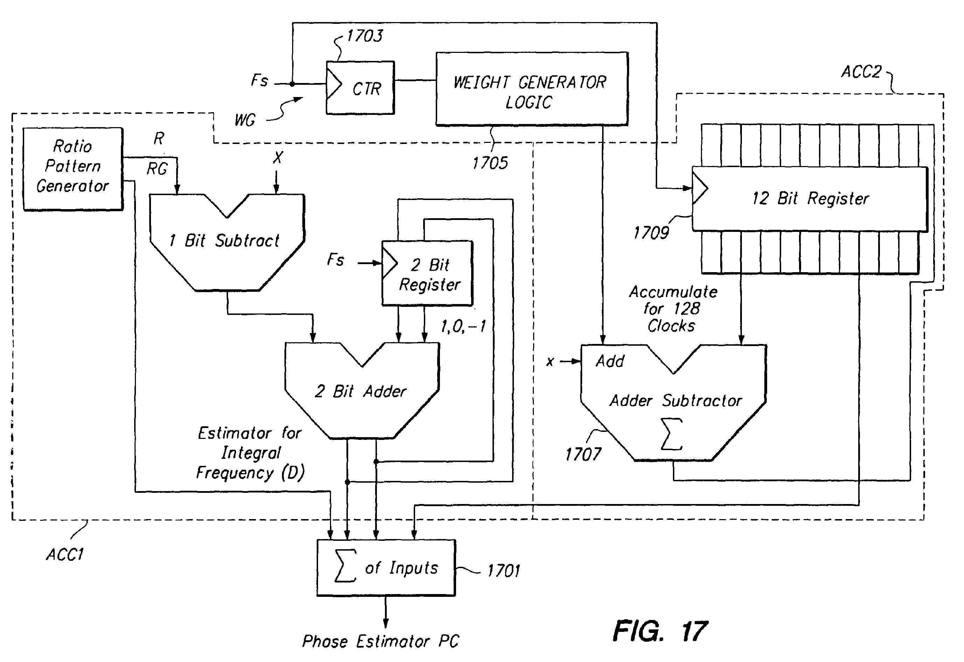

Referring to Figure 17, the clock measure phase estimator includes generally a first accumulator ACC1, a weight generator WG, and a second accumulator ACC2. The estimator additionally includes a summation block 1701.

The accumulator block ACC 1 is substantially the same as the accumulator block ACC1 of Figure 15. Note, however, that the reference pattern generator generates both the reference frequency data stream R, used within the accumulator ACC1, and the clock measure data stream RG which is input to the summation block 1701.

The weight generator includes a counter 1703 and weight generator logic 1705.

The accumulator ACC2 includes an adder 1707 and a register 1709. When X = 1, the weight value from the weight generator is added to the contents of the register 1709. The output of the adder becomes the new input of the register, which performs an accumulator operation for, e.g., 128 clock cycles.

At the conclusion of the accumulation operation of ACC2, the outputs of ACC1 and ACC2, together with the corresponding RG value, are summed in the summation block 1701.

**Claims**

1. A demodulator for demodulating an RF signal without IQ processing, comprising:

   amplitude influencing circuitry (101) responsive to the RF signal outputting an amplitude signal indicative of an amplitude of the RF signal to produce an output signal having amplitude variations at least partially removed; and
   a phase detector (103) responsive to the output signal of the amplitude influencing circuitry (101) for recovering phase information from the RF signal and outputting a phase signal wherein the amplitude influencing circuitry (101) is a fast AGC circuit.

2. The apparatus of Claim 1, further comprising an envelope detector responsive to the RF signal for producing an amplitude signal indicative of the amplitude of the RF signal.

3. The apparatus of Claim 1, further comprising circuitry responsive to the RF signal and to said output signal having amplitude variations at least partially removed for removing phase information from the RF signal and producing a

4. The apparatus of Claim 3, wherein said circuitry for removing phase information is a mixer (605).

5. The apparatus of Claim 4, further comprising a low pass filter (607), coupled to the output signal of said mixer (605), that produces the amplitude signal indicative of the amplitude of the RF signal.

**Patentansprüche**

1. Demodulator zum Demodulieren eines Hochfrequenzsignals ohne IQ-Verarbeitung, umfassend:

   eine amplitudenbeeinflussende Schaltung (101), welche auf das Hochfrequenzsignal reagiert und ein eine Amplitude des Hochfrequenzsignals angebendes Amplitudensignal ausgibt, um ein Ausgabesignal herzustellen, bei welchem Amplitudenvariationen zumindest teilweise entfernt sind; und
   einen Phasendetektor (103), welcher auf das Ausgabesignal der amplitudenbeeinflussenden Schaltung (101) reagiert, um Phaseninformationen aus dem Hochfrequenzsignal wiederherzustellen und ein Phasensignal auszugeben, wobei die amplitudenbeeinflussende Schaltung (101) eine schnelle AGC-Schaltung ist.

2. Gerät nach Anspruch 1, weiterhin umfassend einen Hüllkurvendetektor, welcher auf das Hochfrequenzsignal zum Herstellen eines die Amplitude des Hochfrequenzsignals angebenden Amplitudensignals reagiert.

3. Gerät nach Anspruch 1, weiterhin umfassend eine Schaltung, welche auf das Hochfrequenzsignal und auf das Ausgabesignal, bei welchem Amplitudenvariationen zumindest teilweise entfernt sind, zum Entfernen von Phaseninformationen aus dem Hochfrequenzsignal und zum Herstellen eines entsprechenden Ausgabesignals reagiert.

4. Gerät nach Anspruch 3, wobei die Schaltung zum Entfernen der Phaseninformationen ein Mischer (605) ist.

5. Gerät nach Anspruch 4, weiterhin umfassend einen Tiefpassfilter (607), welcher mit dem Ausgabesignal des Mischers (605) verbunden ist, welcher das die Amplitude des Hochfrequenzsignals angebende Amplitudensignal herstellt.

**Revendications**

1. Démodulateur destiné à démoduler un signal RF sans traitement IQ, comprenant :

   un ensemble de circuits d'influence d'amplitude (101) sensibles au signal RF délivrant en sortie un signal d'amplitude indicatif d'une amplitude du signal RF pour produire un signal de sortie présentant des variations d'amplitude au moins partiellement retirées ; et
   un comparateur de phase (103) sensible au signal de sortie de l'ensemble de circuits d'influence d'amplitude (101) permettant de récupérer des informations de phase à partir du signal RF et de délivrer en sortie un signal de phase, où l'ensemble de circuits d'influence d'amplitude (101) est un circuit AGC rapide.

2. Appareil de la revendication 1, comprenant en outre un détecteur d'enveloppe sensible au signal RF permettant de produire un signal d'amplitude indicatif de l'amplitude du signal RF.

3. Appareil de la revendication 1, comprenant en outre un ensemble de circuits sensibles au signal RF et audit signal de sortie présentant des variations d'amplitude au moins partiellement retirées pour retirer des informations de phase à partir du signal RF et produire un signal de sortie correspondant.

4. Appareil de la revendication 3, dans lequel ledit ensemble de circuits destinés à retirer des informations de phase est un mélangeur (605).

5. Appareil de la revendication 4, comprenant en outre un filtre passe-bas (607), couplé au signal de sortie dudit mélangeur (605), qui produit le signal d'amplitude indicatif de l'amplitude du signal RF.

**FIG. 1**

**FIG. 2**

**FIG. 3**

**FIG. 4**

*501* *503*

LIMITER → PHASE DETECTOR → O(t)

*505*

ENVELOPE DETECTOR → A(t)

**FIG. 5**

*601* *603*

S(t) → FAST AGC → PHASE DETECTOR → O(t)

605 → ⊗ → *607* LPF → A(t)

**FIG. 6**

*701* *703*

S(t) → LIMITER → PHASE DETECTOR → O(t)

705 → ⊗ → *707* LPF → A(t)

**FIG. 7**

Constant Weight

$$F_n = K * \sum_{i=1}^{i=256} W_i * X_{i+n}$$

— Estimate with Straight 256 Wt
- - - True Frequency Ratio

Ave Error = 1772ppm

*Samples*

*FIG. 8*

FIG. 9

EP 1 058 968 B1

**FIG. 10**

| Observed Frequency Data Stream X | Weight W | Fr Ratio = Reference Frequency/ Sample Frequency = |
|:---:|:---:|:---:|
| 1 | 1 | 0.6875 |
| 1 | 2 | |
| 0 | 3 | |
| 1 | 4 | |
| 1 | 5 | |
| 0 | 6 | |
| 1 | 7 | |
| 1 | 8 | |
| 0 | 9 | |
| 1 | 10 | |
| 1 | 11 | |
| 1 | 12 | |
| 0 | 13 | |
| 1 | 14 | |
| 1 | 15 | |
| 0 | 16 | |
| 1 | 17 | |
| 1 | 18 | |
| 0 | 19 | |
| 1 | 20 | |
| 1 | 21 | |
| 0 | 22 | |
| 1 | 23 | |
| 1 | 24 | |
| 0 | 25 | |
| 1 | 26 | |
| 1 | 27 | |
| 1 | 28 | |
| 0 | 29 | |
| 1 | 30 | |
| 1 | 31 | |
| 0 | 32 | |
| 1 | 33 | |
| 1 | 34 | |
| 0 | 35 | |
| 1 | 36 | |
| 1 | 37 | |
| 0 | 38 | |
| 1 | 39 | |
| 1 | 40 | |
| 0 | 41 | |
| 1 | 42 | |
| 1 | 43 | |

*FIG. 11A-1*

| |
|:---:|
| FIG. 11A-1 |
| FIG. 11A-2 |

*FIG. 11A*

| | | | Frequency Estimate | | Integration |
|---|---|---|---|---|---|
| | | | $F_n =$ $\sum_i (W_i * X_{i+n})$ | $\Delta F_i =$ $F_i -Fr$ Ratio | $PF_n =$ $PF_{n-1} * k * \Delta F_i$ |
| | | Correct Phase | $F$ | $\Delta F$ | $Pf$ |
| 0 | 44 | | | | |
| 1 | 45 | | | | |
| 1 | 46 | | | | |
| 1 | 47 | | | | |
| 0 | 48 | | | | |
| 1 | 49 | | | | |
| 1 | 50 | | | | |
| 0 | 51 | | | | |
| 1 | 52 | | | | |
| 1 | 53 | | | | |
| 0 | 54 | | | | |
| 1 | 55 | | | | |
| 1 | 56 | | | | |
| 0 | 57 | | | | |
| 1 | 58 | | | | |
| 1 | 59 | | | | |
| 0 | 60 | | | | |
| 1 | 61 | | | | |
| 1 | 62 | | | | |
| 1 | 63 | | | | |
| 0 | 64 | | | | |
| 1 | 64 | −53.714763 | 0.686058 | −0.001442 | −55.876923 |
| 1 | 63 | −54.394811 | 0.686058 | −0.001442 | −56.615385 |
| 0 | 62 | −55.066978 | 0.686058 | −0.001442 | −57.353846 |
| 1 | 61 | −55.731139 | 0.686058 | −0.001442 | −58.092308 |
| 1 | 60 | −56.387171 | 0.686058 | −0.001442 | −58.830769 |
| 0 | 59 | −57.034949 | 0.686058 | −0.001442 | −59.569231 |
| 1 | 58 | −57.674350 | 0.686058 | −0.001442 | −60.307692 |

## FIG. 11A-2

16

**FIG. 11B**

Ave Error=1.501453

**FIG. 11C**

| Observed Frequency Data Stream X | Weight W | $Y_i = X_i - FrRatio$ <br> Y | $PX_i = PX_{i-1} + Y_i$ <br> Px | Fr Ratio = Reference Frequency/ Sample Frequency = 0.6875 |
|---|---|---|---|---|
| 1 | 1 | 0.3125 | 0.0000 | |
| 1 | 2 | 0.3125 | 0.3125 | |
| 0 | 3 | −0.6875 | −0.3750 | |
| 1 | 4 | 0.3125 | −0.0625 | |
| 1 | 5 | 0.3125 | 0.2500 | |
| 0 | 6 | −0.6875 | −0.4375 | |
| 1 | 7 | 0.3125 | −0.1250 | |
| 1 | 8 | 0.3125 | 0.1875 | |
| 0 | 9 | −0.6875 | −0.5000 | |
| 1 | 10 | 0.3125 | −0.1875 | |
| 1 | 11 | 0.3125 | 0.1250 | |
| 1 | 12 | 0.3125 | 0.4375 | |
| 0 | 13 | −0.6875 | −0.2500 | |
| 1 | 14 | 0.3125 | 0.0625 | |
| 1 | 15 | 0.3125 | 0.3750 | |
| 0 | 16 | −0.6875 | −0.3125 | |
| 1 | 17 | 0.3125 | 0.0000 | |
| 1 | 18 | 0.3125 | 0.3125 | |
| 0 | 19 | −0.6875 | −0.3750 | |
| 1 | 20 | 0.3125 | −0.0625 | |
| 1 | 21 | 0.3125 | 0.2500 | |
| 0 | 22 | −0.6875 | −0.4375 | |
| 1 | 23 | 0.3125 | −0.1250 | |
| 1 | 24 | 0.3125 | 0.1875 | |
| 0 | 25 | −0.6875 | −0.5000 | |
| 1 | 26 | 0.3125 | −0.1875 | |
| 1 | 27 | 0.3125 | 0.1250 | |
| 1 | 28 | 0.3125 | 0.4375 | |
| 0 | 29 | −0.6875 | −0.2500 | |
| 1 | 30 | 0.3125 | 0.0625 | |
| 1 | 31 | 0.3125 | 0.3750 | |
| 0 | 32 | −0.6875 | −0.3125 | |
| 1 | 33 | 0.3125 | 0.0000 | |
| 1 | 34 | 0.3125 | 0.3125 | |
| 0 | 35 | −0.6875 | −0.3750 | |
| 1 | 36 | 0.3125 | −0.0625 | |
| 1 | 37 | 0.3125 | 0.2500 | |
| 0 | 38 | −0.6875 | −0.4375 | |
| 1 | 39 | 0.3125 | −0.1250 | |
| 1 | 40 | 0.3125 | 0.1875 | |
| 0 | 41 | −0.6875 | −0.5000 | |
| 1 | 42 | 0.3125 | −0.1875 | |
| 1 | 43 | 0.3125 | 0.1250 | |

**FIG. 12A-1**

**FIG. 12A-1**

**FIG. 12A-2**

**FIG. 12A**

| | | | | Correct Phase | $PP_n = \dfrac{k*\sum_i (W_i + PX_{i+n})}{PP}$ |
|---|---|---|---|---|---|
| 0 | 44 | −0.6875 | −0.5625 | | |
| 1 | 45 | 0.3125 | −0.2500 | | |
| 1 | 46 | 0.3125 | 0.0625 | | |
| 1 | 47 | 0.3125 | 0.3750 | | |
| 0 | 48 | −0.6875 | −0.3125 | | |
| 1 | 49 | 0.3125 | 0.0000 | | |
| 1 | 50 | 0.3125 | 0.3125 | | |
| 0 | 51 | −0.6875 | −0.3750 | | |
| 1 | 52 | 0.3125 | −0.0625 | | |
| 1 | 53 | 0.3125 | 0.2500 | | |
| 0 | 54 | −0.6875 | −0.4375 | | |
| 1 | 55 | 0.3125 | −0.1250 | | |
| 1 | 56 | 0.3125 | 0.1875 | | |
| 0 | 57 | −0.6875 | −0.5000 | | |
| 1 | 58 | 0.3125 | −0.1875 | | |
| 1 | 59 | 0.3125 | 0.1250 | | |
| 0 | 60 | −0.6875 | −0.5625 | | |
| 1 | 61 | 0.3125 | −0.2500 | | |
| 1 | 62 | 0.3125 | 0.0625 | | |
| 1 | 63 | 0.3125 | 0.3750 | | |
| 0 | 64 | −0.6875 | −0.3125 | | |
| 1 | 64 | 0.3125 | 0.0000 | −53.714763 | −55.876923 |
| 1 | 63 | 0.3125 | 0.3125 | −54.394811 | −56.615385 |
| 0 | 62 | −0.6875 | −0.3750 | −55.066976 | −57.353846 |
| 1 | 61 | 0.3125 | −0.0625 | −55.731139 | −58.092308 |
| 1 | 60 | 0.3125 | 0.2500 | −56.387171 | −58.830769 |
| 0 | 59 | −0.6875 | −0.4376 | −57.034949 | −59.569231 |
| 1 | 58 | 0.3125 | −0.1250 | −57.674350 | −60.307692 |

## FIG. 12A-2

**FIG. 12B**

Ave Error= 1.501453

**FIG. 12C**

FIG. 13

| Reference Frequency Data Stream R | Observed Frequency Data System X | $D_i =$ $D_{i-1}+X_i-Ri$ D | Weight W | Fr Ratio= Reference Frequency/ Sample Frequency = 0.6875 |
|---|---|---|---|---|
| 1 | 1 | 0 | 1 | |
| 1 | 1 | 0 | 2 | |
| 0 | 0 | 0 | 3 | |
| 1 | 1 | 0 | 4 | |
| 1 | 1 | 0 | 5 | |
| 0 | 0 | 0 | 6 | |
| 1 | 1 | 0 | 7 | |
| 1 | 1 | 0 | 8 | |
| 1 | 0 | −1 | 9 | |
| 0 | 1 | 0 | 10 | |
| 1 | 1 | 0 | 11 | |
| 1 | 1 | 0 | 12 | |
| 0 | 0 | 0 | 13 | |
| 1 | 1 | 0 | 14 | |
| 1 | 1 | 0 | 15 | |
| 0 | 0 | 0 | 16 | |
| 1 | 1 | 0 | 17 | |
| 1 | 1 | 0 | 18 | |
| 0 | 0 | 0 | 19 | |
| 1 | 1 | 0 | 20 | |
| 1 | 1 | 0 | 21 | |
| 0 | 0 | 0 | 22 | |
| 1 | 1 | 0 | 23 | |
| 1 | 1 | 0 | 24 | |
| 1 | 0 | −1 | 25 | |
| 0 | 1 | 0 | 26 | |
| 1 | 1 | 0 | 27 | |
| 1 | 1 | 0 | 28 | |
| 0 | 0 | 0 | 29 | |
| 1 | 1 | 0 | 30 | |
| 1 | 1 | 0 | 31 | |
| 0 | 0 | 0 | 32 | |
| 1 | 1 | 0 | 33 | |
| 1 | 1 | 0 | 34 | |
| 0 | 0 | 0 | 35 | |
| 1 | 1 | 0 | 36 | |
| 1 | 1 | 0 | 37 | |
| 0 | 0 | 0 | 38 | |
| 1 | 1 | 0 | 39 | |
| 1 | 1 | 0 | 40 | |
| 1 | 0 | −1 | 41 | |
| 0 | 1 | 0 | 42 | |

FIG. 14A-1

FIG. 14A-1

FIG. 14A-2

FIG. 14A

| | | | | Correct Phase | $PI_n=$ $k_0+k_1*\sum_i(W_i*D_{i+n})$ F |
|---|---|---|---|---|---|
| 1 | 1 | 0 | 43 | | |
| 1 | 0 | −1 | 44 | | |
| 0 | 1 | 0 | 45 | | |
| 1 | 1 | 0 | 46 | | |
| 1 | 1 | 0 | 47 | | |
| 0 | 0 | 0 | 48 | | |
| 1 | 1 | 0 | 49 | | |
| 1 | 1 | 0 | 50 | | |
| 0 | 0 | 0 | 51 | | |
| 1 | 1 | 0 | 52 | | |
| 1 | 1 | 0 | 53 | | |
| 0 | 0 | 0 | 54 | | |
| 1 | 1 | 0 | 55 | | |
| 1 | 1 | 0 | 56 | | |
| 1 | 0 | −1 | 57 | | |
| 0 | 1 | 0 | 58 | | |
| 1 | 1 | 0 | 59 | | |
| 1 | 0 | −1 | 60 | | |
| 0 | 1 | 0 | 61 | | |
| 1 | 1 | 0 | 62 | | |
| 1 | 1 | 0 | 63 | | |
| 0 | 0 | 0 | 64 | | |
| 1 | 1 | 0 | 64 | −53.714763 | −55.876923 |
| 1 | 1 | 0 | 63 | −54.394811 | −56.615385 |
| 0 | 0 | 0 | 62 | −55.066978 | −57.353846 |
| 1 | 1 | 0 | 61 | −55.731139 | −58.092308 |
| 1 | 1 | 0 | 60 | −56.387171 | −58.830769 |
| 0 | 0 | 0 | 59 | −57.034949 | −59.569231 |
| 1 | 1 | 0 | 58 | −57.674350 | −60.307692 |

$k_0 = 16$

## FIG. 14A-2

23

**FIG. 14B**

Ave Error= 1.501453

**FIG. 14C**

EP 1 058 968 B1

*FIG. 15*

25

| Reference Frequency Generator RG | Reference Frequency Data Stream R | Observed Frequency Data System X | $D_i = D_{i-1} + X_i - Ri$ | | Fr Ratio= Reference Frequency/ Sample Frequency = 0.6875 |
|---|---|---|---|---|---|
| | | | D | Weight W | |
| 1.5 | 1 | 1 | 0 | −0.5 | |
| 1.1875 | 1 | 1 | 0 | −2 | |
| 0.875 | 0 | 0 | 0 | −4.5 | |
| 1.5625 | 1 | 1 | 0 | −8 | |
| 1.25 | 1 | 1 | 0 | −12.5 | |
| 0.9375 | 0 | 0 | 0 | −18 | |
| 1.625 | 1 | 1 | 0 | −24.5 | |
| 1.3125 | 1 | 1 | 0 | −32 | |
| 1 | 1 | 0 | −1 | −40.5 | |
| 0.6675 | 0 | 1 | 0 | −50 | |
| 1.375 | 1 | 1 | 0 | −60.5 | |
| 1.0625 | 1 | 1 | 0 | −72 | |
| 0.75 | 0 | 0 | 0 | −84.5 | |
| 1.4375 | 1 | 1 | 0 | −98 | |
| 1.125 | 1 | 1 | 0 | −112.5 | |
| 0.8125 | 0 | 0 | 0 | −128 | |
| 1.5 | 1 | 1 | 0 | −144.5 | |
| 1.1875 | 1 | 1 | 0 | −162 | |
| 0.875 | 0 | 0 | 0 | −180.5 | |
| 1.5625 | 1 | 1 | 0 | −200 | |
| 1.25 | 1 | 1 | 0 | −220.5 | |
| 0.9375 | 0 | 0 | 0 | −242 | |
| 1.625 | 1 | 1 | 0 | −264.5 | |
| 1.3125 | 1 | 1 | 0 | −288 | |
| 1 | 1 | 0 | −1 | −312.5 | |
| 0.6875 | 0 | 1 | 0 | −338 | |
| 1.375 | 1 | 1 | 0 | −364.5 | |
| 1.0625 | 1 | 1 | 0 | −392 | |
| 0.75 | 0 | 0 | 0 | −420.5 | |
| 1.4375 | 1 | 1 | 0 | −450 | |
| 1.125 | 1 | 1 | 0 | −480.5 | |
| 0.8125 | 0 | 0 | 0 | −512 | |
| 1.5 | 1 | 1 | 0 | −644.5 | |
| 1.1875 | 1 | 1 | 0 | −578 | |
| 0.875 | 0 | 0 | 0 | −612.5 | |
| 1.5625 | 1 | 1 | 0 | −648 | |
| 1.25 | 1 | 1 | 0 | −684.5 | |
| 0.9375 | 0 | 0 | 0 | −722 | |
| 1.625 | 1 | 1 | 0 | −760.6 | |
| 1.3125 | 1 | 1 | 0 | −800 | |
| 1 | 1 | 0 | −1 | −840.5 | |
| 0.6875 | 0 | 1 | 0 | 882 | |

FIG. 16A-1

FIG. 16A-2

FIG. 16A

FIG. 16A-1

EP 1 058 968 B1

| | | | | | Correct Phase | $PC_n = k*(D_n - frac(RG_n) + 0.5 + \sum_i (W_i * X_{i+n-64}))$ PC |
|---|---|---|---|---|---|---|
| 1.375 | 1 | 1 | 0 | −924.5 | | |
| 1.0625 | 1 | 0 | −1 | −968 | | |
| 0.75 | 0 | 1 | 0 | −1012.5 | | |
| 1.4375 | 1 | 1 | 0 | −1068 | | |
| 1.125 | 1 | 1 | 0 | −1104.5 | | |
| 0.8125 | 0 | 0 | 0 | −1152 | | |
| 1.5 | 1 | 1 | 0 | −1200.5 | | |
| 1.1875 | 1 | 1 | 0 | −1250 | | |
| 0.875 | 0 | 0 | 0 | −1300.5 | | |
| 1.5625 | 1 | 1 | 0 | −1352 | | |
| 1.25 | 1 | 1 | 0 | −1404.5 | | |
| 0.9375 | 0 | 0 | 0 | −1458 | | |
| 1.625 | 1 | 1 | 0 | −1512.5 | | |
| 1.3125 | 1 | 1 | 0 | −1568 | | |
| 1 | 1 | 0 | −1 | −1624.5 | | |
| 0.6875 | 0 | 1 | 0 | −1682 | | |
| 1.375 | 1 | 1 | 0 | −1740.5 | | |
| 1.0625 | 1 | 0 | −1 | −1800 | | |
| 0.75 | 0 | 1 | 0 | −1860.5 | | |
| 1.4375 | 1 | 1 | 0 | −1922 | | |
| 1.125 | 1 | 1 | 0 | −1984.5 | | |
| 0.8125 | 0 | 0 | 0 | −2048 | | |
| 1.5 | 1 | 1 | 0 | 2048 | −53.374738 | −55.507692 |
| 1.1875 | 1 | 1 | 0 | 1984.5 | −54.054787 | −56.246154 |
| 0.875 | 0 | 0 | 0 | 1922 | −54.730895 | −56.984615 |
| 1.5625 | 1 | 1 | 0 | 1860.5 | −55.399059 | −57.723077 |
| 1.25 | 1 | 1 | 0 | 1800 | −56.059155 | −58.461538 |
| 0.9375 | 0 | 0 | 0 | 1740.5 | −56.711060 | −59.200000 |
| 1.625 | 1 | 1 | 0 | 1682 | −57.354650 | −59.938462 |
| 1.3125 | 1 | 1 | 0 | 1624.5 | −57.939800 | −60.676923 |

*FIG. 16A-2*

**FIG. 16B**

Ave Error= 1.501476

**FIG. 16C**

FIG. 17

EP 1 058 968 B1

ACCUMULATION   QUANTIZATION

**FIG. 18**

EP 1 058 968 B1

| $G_n = G_{n-1} + 0.6875 - INT(G_{n-1})$ Accumulator | $R_n = INT(G_n)$ Data Stream |
|---|---|
| 0.6875 | 0 |
| 1.375 | 1 |
| 1.0625 | 1 |
| 0.75 | 0 |
| 1.4375 | 1 |
| 1.125 | 1 |
| 0.8125 | 0 |
| 1.5 | 1 |
| 1.1875 | 1 |
| 0.875 | 0 |
| 1.5625 | 1 |
| 1.25 | 1 |
| 0.9375 | 0 |
| 1.625 | 1 |
| 1.3125 | 1 |
| 1 | 1 |
| 0.6875 | 0 |

**FIG. 19**

**FIG. 20**

Fig. 21

**FIG. 22**

**FIG. 23**

FIG. 24

EP 1 058 968 B1

## REFERENCES CITED IN THE DESCRIPTION

**Patent documents cited in the description**

- US 00693898 A

**Non-patent literature cited in the description**

- *IEEE Transactions on Vehicular Technology,* 01 February 1996, vol. 45 (1

- **CANDY et al.** Oversampling Delta-Sigma Data Converters. IEEE Press, 1992, 1-6